(19) Europäisches Patentamt
European Patent Office
Office européen des brevets

(11) **EP 2 529 604 B1**

(12) **EUROPÄISCHE PATENTSCHRIFT**

(45) Veröffentlichungstag und Bekanntmachung des Hinweises auf die Patenterteilung:
**21.09.2016   Patentblatt 2016/38**

(21) Anmeldenummer: **11763579.7**

(22) Anmeldetag: **29.07.2011**

(51) Int Cl.:
*H05K 1/02* (2006.01)          *H05K 1/11* (2006.01)
*H01R 13/717* (2006.01)       *H05K 1/14* (2006.01)

(86) Internationale Anmeldenummer:
**PCT/DE2011/001533**

(87) Internationale Veröffentlichungsnummer:
**WO 2012/028132 (08.03.2012 Gazette 2012/10)**

(54) **LICHTQUELLENVORRICHTUNG AUF EINER LEITERPLATTE UND LICHTQUELLENANORDNUNG MIT MEHREREN LICHTQUELLENVORRICHTUNGEN**

LIGHT SOURCE ON A PRINTED CIRCUIT BOARD AND ARRANGEMENT OF LIGHT SOURCES

SOURCE LUMINEUSE SUR UNE CARTE IMPRIMÉE ET ARRANGEMENT DE SOURCES LUMINEUSES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.08.2010   DE 102010039956**

(43) Veröffentlichungstag der Anmeldung:
**05.12.2012   Patentblatt 2012/49**

(73) Patentinhaber: **OSRAM OLED GmbH**
**93049 Regensburg (DE)**

(72) Erfinder:
• **DIEKMANN, Karsten**
**94371 Rattenberg (DE)**
• **ROSSBACH, Steven**
**08626 Adorf (DE)**

(74) Vertreter: **Viering, Jentschura & Partner mbB**
**Patent- und Rechtsanwälte**
**Am Brauhaus 8**
**01099 Dresden (DE)**

(56) Entgegenhaltungen:
DE-A1-102007 042 761       DE-C1- 10 012 734
DE-U1- 29 818 609             US-A1- 2010 103 649

**Beschreibung**

Die Erfindung betrifft eine Lichtquellenvorrichtung und eine Lichtquellenanordnung.

Um ein homogenes Leuchtbild von einer Lichtquellenvorrichtung, beispielsweise von einer Flächenlichtquellen, im Folgenden auch bezeichnet als Flächenstrahler (zum Beispiel OLED-Lichtkacheln (OLED: Organische Leuchtdiode), LED-Leuchtplatten (LED: Leuchtdiode) oder OLEC-Lichtquelle (OLEC: auf Kohlenstoff basierende organische Leuchtdiode), zu erreichen, werden üblicherweise allseitige Kontaktierungen eingesetzt. Dazu sind sowohl auf einer einzelnen Flächenlichtquelle elektrische Verbindungen notwendig als auch zwischen mehreren dieser Flächenlichtquellen. Diese elektrischen Verbindungen und deren elektrische Rückleitung zu mindestens einer gemeinsamen Anschlussstelle benötigen Platz, was insbesondere im Bereich einer Flächenlichtquelle selbst zu einem erhöhten Flächenbedarf bzw. einer erhöhten Gesamtdicke führt. An Stellen, an denen mehrere Drähte isoliert voneinander übereinander geführt werden müssen (Kreuzungspunkte), führt dies sogar zu fast einer Verdoppelung der durch die Kabel bestimmten Dicke der Lichtquellenvorrichtung.

Eine Reihenschaltung oder eine Parallelschaltung der einzelnen Kontakte auf einer Flächenlichtquelle oder zwischen mehreren dieser Flächenlichtquellen wurde bisher durch Drähte realisiert, die einzeln verlegt werden müssen und Platz benötigen. Rückleitungen werden bisher üblicherweise hinter den Flächenlichtquellen verlegt, wobei der Dickenauftrag und der Mehraufwand in Kauf genommen wurden.

Von der Firma LEDON OLED Lighting GmbH & Co. KG ist eine OLED-Lichtquellenvorrichtung bekannt, bei der die OLED auf einer gedruckten Leiterplatte (Printed Circuit Board, PCB) angeordnet ist.

DE 10 2007 042 761 A1 zeigt eine Anordnung von mehreren LEDs auf einer Leiterplatte, wobei die Leiterplatte an ihren Seiten Kontaktstellen zum elektrischen Kontaktieren aufweist und wobei die Kontaktstellen so angeordnet sind, dass sich mehrere Leiterplatten auf einfache Art und Weise zusammen schalten lassen.

Die Erfindung ist durch den unabhängigen Anspruch 1 definiert.

In verschiedenen Ausführungsbeispielen wird eine Lichtquellenvorrichtung bereitgestellt, bei der bei einer Verschaltung mehrerer Lichtquellenvorrichtungen zu einer Lichtquellenanordnung eine Reduktion der Dicke der gebildeten Lichtquellenanordnung bei Bereitstellung einer elektrischen Rückführung über eine oder mehrere Lichtquellenvorrichtungen ermöglicht wird.

Eine Lichtquellenvorrichtung weist auf: eine Lichtquelle; einen mit der Lichtquelle gekoppelten Eingangsanschluss zum Zuführen einer Eingangsspannung; einen mit der Lichtquelle gekoppelten Ausgangsanschluss zum Bereitstellen einer Ausgangsspannung; einen ersten Überbrückungsanschluss und einen zweiten Überbrückungsanschluss; und eine mit der Lichtquelle gekoppelte Leiterplatte. Die Leiterplatte weist mindestens eine Leiterbahn auf, die mit dem ersten Überbrückungsanschluss und dem zweiten Überbrückungsanschluss gekoppelt ist zum die Lichtquelle überbrückenden Führen eines elektrischen Potentials von dem ersten Überbrückungsanschluss zu dem zweiten Überbrückungsanschluss.

In einer Ausgestaltung weist der Eingangsanschluss einen ersten Potential-Eingangsanschluss zum Zuführen eines ersten elektrischen Potentials und einen zweiten Potential-Eingangsanschluss zum Zuführen eines zweiten elektrischen Potentials auf.

In einer Ausgestaltung ist das zweite elektrische Potential unterschiedlich zu dem ersten elektrischen Potential. Dies ist beispielsweise bei einer Serienschaltung mehrerer Lichtquellenvorrichtungen vorgesehen. Alternativ kann das zweite elektrische Potential gleich dem ersten elektrischen Potential sein. Dies ist beispielsweise bei einer Parallelschaltung mehrerer Lichtquellenvorrichtungen vorgesehen.

In einer Ausgestaltung weist der Ausgangsanschluss einen ersten Potential-Ausgangsanschluss zum Bereitstellen eines zweiten elektrischen Potentials und einen zweiten Potential-Ausgangsanschluss zum Bereitstellen des ersten elektrischen Potentials auf.

Gemäß einer anderen Weiterbildung kann die Lichtquelle als eine Flächenlichtquelle, auch bezeichnet als Flächenstrahler oder als Flächenstrahler-Lichtquelle, eingerichtet sein.

Eine Flächenlichtquelle kann in verschiedenen Ausführungsbeispielen als eine Lichtquelle verstanden werden, das Licht erzeugt von einer Quelle, die eine Flächenausdehnung hat, im Gegensatz zu einer Punktlichtquelle, wie beispielsweise einer Glühlampe. Verschiedene Beispiele einer Flächenlichtquelle sind Leuchtdioden (LED), beispielsweise in Form einer eine Mehrzahl von miteinander gekoppelten LEDs aufweisenden LED-Leuchtplatte, organische Leuchtdioden (OLED), beispielsweise in Form einer eine Mehrzahl von miteinander gekoppelten OLEDs aufweisenden OLED-Lichtkachel, eine OLEC-Lichtquelle (wobei unter einer OLEC eine auf Kohlenstoff basierende organische Leuchtdiode verstanden wird), beispielsweise in Form einer eine Mehrzahl von miteinander gekoppelten OLECs aufweisenden OLEC-Lichtkachel.

Die Leiterplatte kann eine Schicht oder mehrere Schichten aufweisen, beispielsweise mit einer Leiterbahnebene oder mit mehreren Leiterbahnebenen (jeweils aufweisend beispielsweise eine oder mehrere Leiterbahnen). Die Leiterplatte kann als eine flexible Leiterplatte eingerichtet sein.

Der Eingangsanschluss (und damit gegebenenfalls der eine Potential-Eingangsanschluss oder die mehreren Potential-Eingangsanschlüsse) kann in verschiedenen Ausführungsbeispielen auf der Leiterplatte angeordnet sein.

Weiterhin kann in verschiedenen Ausführungsbeispielen der Ausgangsanschluss (und damit gegebenenfalls der eine Potential-Ausgangsanschluss oder die mehreren Potential-Ausgangsanschlüsse) auf der Leiterplatte angeordnet sein.

Ferner können/kann in verschiedenen Ausführungsbeispielen der erste Überbrückungsanschluss und/oder der zweite Überbrückungsanschluss auf der Leiterplatte angeordnet sein.

Eine Lichtquellenanordnung kann vorgesehen sein mit einer Mehrzahl miteinander elektrisch gekoppelten Lichtquellenvorrichtungen (in Serienschaltung und/oder in Parallelschaltung der Lichtquellenvorrichtungen) gemäß verschiedenen Ausführungsbeispielen.

Ausführungsbeispiele der Erfindung sind in den Figuren dargestellt und werden im Folgenden näher erläutert.

Es zeigen

Figur 1    eine Draufsicht auf eine Lichtquellenvorrichtung gemäß einem Ausführungsbeispiel;

Figur 2    eine Querschnittsansicht durch eine Lichtquelle der Lichtquellenvorrichtung aus Figur 1 gemäß einem Ausführungsbeispiel;

Figur 3    zeigt eine Draufsicht auf eine Lichtquellenanordnung gemäß einem Ausführungsbeispiel;

Figur 4    eine Draufsicht auf eine Lichtquellenvorrichtung gemäß einem Ausführungsbeispiel;

Figur 5    eine Draufsicht auf eine Lichtquellenvorrichtung gemäß einem Ausführungsbeispiel; und

Figur 6    eine Lichtquellenanordnung gemäß einem Ausführungsbeispiel.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

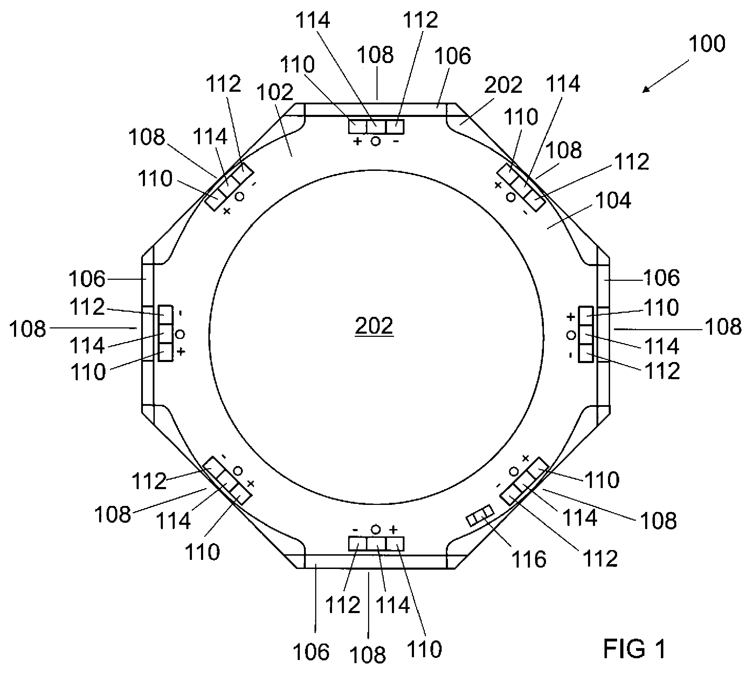

**Fig.1** zeigt eine Draufsicht auf eine Lichtquellenvorrichtung 100 gemäß einem Ausführungsbeispiel. In verschiedenen Ausführungsbeispielen weist die Lichtquellenvorrichtung 100 mindestens eine organische Leuchtdiode (OLED) auf. In anderen Ausführungsbeispielen kann die Lichtquellenvorrichtung 100 jedoch auch beliebige andere Flächenlichtquellen aufweisen, beispielsweise eine oder mehrere Leuchtdioden (LED), beispielsweise in Form von einer LED-Leuchtplatte oder eine oder mehrere auf Kohlenstoff basierende organische Leuchtdiode(n) (OLEC). Die Lichtquellenvorrichtung 100 bildet anschaulich ein Lichtquellenmodul, welches mit anderen Lichtquellenmodulen in beliebiger Weise verschaltet werden kann.

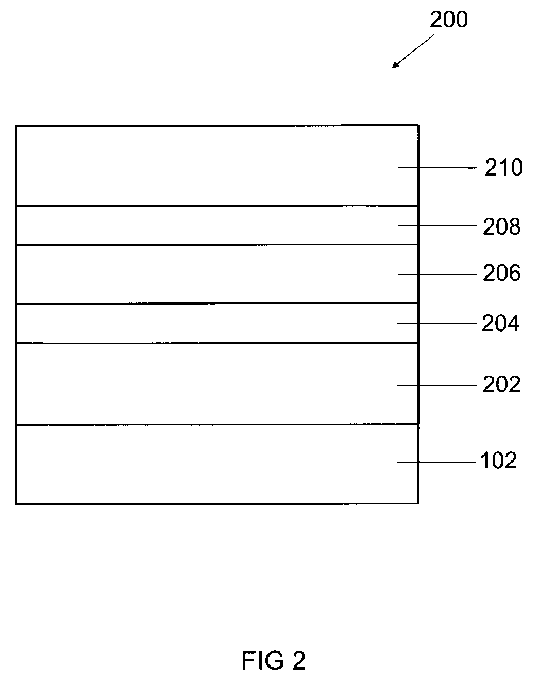

**Fig.2** zeigt eine Querschnittsansicht durch die Lichtquellenvorrichtung 100 aus Fig.1 gemäß einem Ausführungsbeispiel mit einer OLED als Lichtquelle. Es ist anzumerken, dass eine beliebig anders aufgebaute OLED in der Lichtquellenvorrichtung 100 in verschiedenen Ausführungsbeispielen vorgesehen sein kann.

In verschiedenen Ausführungsbeispielen weist die Lichtquelle 200, beispielsweise die OLED, der Lichtquellenvorrichtung 100 ein Substrat 202 auf sowie eine erste Elektrode 204, im Folgenden auch bezeichnet als Grundelektrode 204, die auf dem Substrat aufgebracht ist, beispielsweise abgeschieden.

Ein "substrat" 202, wie es hierin verwendet wird, kann zum Beispiel ein für ein elektronisches Bauelement üblicherweise verwendetes Substrat 202 aufweisen. Das Substrat 202 kann ein transparentes Substrat 202 sein. Das Substrat 202 kann jedoch auch ein nicht transparentes Substrat 202 sein. Beispielsweise kann das Substrat 202 Glas, Quarz, Saphir, Kunststofffolie(n), Metall, Metallfolie(n), Siliziumwafer oder ein anderes geeignetes Substratmaterial aufweisen. Ein Metallsubstrat wird beispielsweise verwendet, wenn nicht direkt darauf die Elektroden-Aufwachsschicht angeordnet ist. Als Substrat 202 wird in verschiedenen Ausgestaltungen die Schicht verstanden, auf der bei der Herstellung der Lichtquellenvorrichtung 100 nachfolgend alle anderen Schichten aufgebracht werden. Solche nachfolgenden Schichten können z.B. bei einer Lichtquellenvorrichtung 100 für die Strahlungsemission erforderliche Schichten sein.

Das Substrat 202 kann ein transparentes Substrat 202 sein. Das Substrat 202 kann jedoch auch ein nicht transparentes Substrat 202 sein. Beispielsweise kann das Substrat Glas, Quarz, Saphir, Kunststofffolie(n), Metall, Metallfolie(n), Siliziumwafer oder ein anderes geeignetes Substratmaterial aufweisen. Ein Metallsubstrat kann beispielsweise verwendet werden, wenn nicht direkt darauf die Elektroden-Aufwachsschicht, wie sie im Folgenden noch näher erläutert wird, angeordnet ist. In verschiedenen Ausführungsbeispielen kann die Grundelektrode 204 beispielsweise eine Anode sein und beispielsweise aus Indium-dotiertem Zinnoxid (ITO) gebildet sein oder werden.

Die erste Elektrode 204 kann eine Anode oder eine Kathode sein. Die erste Elektrode 204 kann lochinjizierende oder elektroneninjizierende Funktionen aufweisen.

In verschiedenen Ausführungsbeispielen können/kann das Substrat 202 und/oder die erste Elektrode 204 transparent ausgebildet sein.

In verschiedenen Ausführungsbeispielen kann die erste Elektrode 204 mittels Sputterns oder mittels thermischen Verdampfens aufgebracht werden. In verschiedenen Ausführungsbeispielen kann die erste Elektrode 204 eine Schichtdicke aufweisen in einem Bereich von ungefähr 5 nm bis ungefähr 300 nm, beispielsweise eine Schichtdicke in einem Bereich von ungefähr 100 nm bis ungefähr 200 nm.

In verschiedenen Ausführungsbeispielen ist oder sind auf der ersten Elektrode 204 eine oder mehrere organische Funktionsschichten 206 zum Ladungstransport und zur Lichterzeugung, wie beispielsweise eine fluoreszierende und/oder eine phosphoreszierende Emitterschicht, aufgebracht.

Beispiele für Emittermaterialien, die in einer OLED gemäß verschiedenen Ausführungsbeispielen vorgesehen werden können, schließen organische oder organometallische Verbindungen, wie Derivate von Polyfluoren, Polythiophen und Polyphenylen (z.B. 2- oder 2,5-substituiertes Poly-p-phenylenvinylen) sowie Metallkomplexe, beispielsweise Iridium-Komplexe wie blau phosphoreszierendes FIrPic (Bis(3,5-difluoro-2-(2-pyridyl)phenyl-(2-carboxypyridyl)-iridium III), grün phosphoreszierendes Ir(ppy)$_3$ (Tris(2-phenylpyridin)iridium III), rot phosphoreszierendes Ru (dtb-bpy)$_3$*2(PF$_6$) (Tris[4,4'-di-tert-butyl-(2,2')-bipyridin]ruthenium(III)komplex) sowie blau fluoreszierendes DPAVBi (4,4-Bis[4-(dip-tolylamino)styryl]biphenyl), grün fluoreszierendes TTPA (9,10-Bis[N,N-di-(p-tolyl)-amino]anthracen) und rot fluoreszierendes DCM2 (4-Dicyanomethylen)-2-methyl-6-julolidyl-9-enyl-4H-pyran) als nichtpolymere Emitter ein. Solche nichtpolymeren Emitter sind beispielsweise mittels thermischen Verdampfens abscheidbar. Ferner können Polymeremitter eingesetzt werden, welche insbesondere mittels nasschemischen Verfahren, wie beispielsweise Spin Coating, abscheidbar sind.

Die Emittermaterialien können in geeigneter Weise in einem Matrixmaterial eingebettet sein.

Die Emittermaterialien der Emitterschichten der OLED können beispielsweise so ausgewählt sein, dass das elektronische Bauelement Weißlicht emittiert. Die Emitterschicht kann mehrere verschiedenfarbig (zum Beispiel blau und gelb oder blau, grün und rot) emittierende Emittermaterialien aufweisen, alternativ kann die Emitterschicht auch aus mehreren Teilschichten aufgebaut sein, wie einer blau fluoreszierenden Emitterschicht, einer grün phosphoreszierenden Emitterschicht und einer rot phosphoreszierenden Emitterschicht. Durch die Mischung der verschiedenen Farben kann die Emission von Licht mit einem weißen Farbeindruck resultieren. Alternativ kann auch vorgesehen sein, im Strahlengang der durch diese Schichten erzeugten Primäremission ein Konvertermaterial anzuordnen, das die Primärstrahlung zumindest teilweise absorbiert und eine Sekundärstrahlung anderer Wellenlänge emittiert, so dass sich aus einer (noch nicht weißen) Primärstrahlung durch die Kombination von primärer und sekundärer Strahlung ein weißer Farbeindruck ergibt.

Es können weitere organische Funktionsschichten vorgesehen sein, die beispielsweise dazu dienen, die Funktionalität und damit die Effizienz des elektronischen Bauelements weiter zu verbessern.

Es ist darauf hinzuweisen, dass in alternativen Ausführungsbeispielen jede geeignete Form von lichtemittierenden Funktionsschichten, beispielsweise organische Funktionsschichten vorgesehen sein können und die Erfindung nicht beschränkt ist auf eine spezielle Art von Funktionsschicht(en).

In verschiedenen Ausführungsbeispielen kann optional auf der einen oder den mehreren organischen Funktionsschichten 206 ein transparenter elektrisch leitfähiger (beispielsweise metallischer) Deckkontakt 208, beispielsweise in Form einer zweiten Elektrode 208, abgeschieden sein. Die zweite Elektrode 208 kann gebildet werden, indem eine (beispielsweise optisch transparente) Metallschicht mit einer Schichtdicke aufgebracht wird von 5 nm bis ungefähr 300 nm, beispielsweise eine Schichtdicke in einem Bereich von ungefähr 100 nm bis ungefähr 200 nm.

Die Metallschicht kann mindestens eines der folgenden Metalle aufweisen: Aluminium, Barium, Indium, Silber, Kupfer, Gold, Magnesium, Samarium, Platin, Palladium, Calcium und Lithium sowie Kombinationen derselben oder dieses Metall oder eine Verbindung aus diesem Metall oder aus mehreren dieser Metalle, beispielsweise eine Legierung.

Die die Metallschicht aufweisende zweite Elektrode 208 ist beispielsweise, wenn die erste Elektrode 204 eine Anode ist, eine Kathode.

In verschiedenen Ausführungsbeispielen weist die transparente metallische Deckelektrode 208 eine 10 nm dicke Schicht aus Silber auf oder besteht aus derselben, wobei die transparente metallische Deckelektrode 208 mittels thermischen Verdampfens aufgebracht werden kann.

In verschiedenen Ausführungsbeispielen weist die transparente metallische Deckelektrode 208 eine 10 nm dicke Schicht aus Silber auf oder besteht aus derselben, wobei die transparente metallische Deckelektrode 208 mittels thermischen Verdampfens aufgebracht werden kann.

Wie weiterhin in Fig.2 gezeigt ist, wird auf die freie Oberfläche des transparenten elektrisch leitfähigen Deckkontakts 208 eine optische Anpassungsschicht 210 zur Lichtauskopplung aufgebracht, beispielsweise abgeschieden oder gesputtert.

Die in Fig.2 dargestellte OLED als eine Implementierung einer Lichtquellenvorrichtung 100 gemäß verschiedenen Ausführungsbeispielen ist als Top-/Bottom-Emitter ausgestaltet. In alternativen Ausführungsbeispielen kann die Lichtquellenvorrichtung 100 als "Bottom-Emitter" oder als "Top-Emitter" ausgeführt sein.

Ganz allgemein gilt, dass bei einem Top-Emitter oder einem Bottom-Emitter eine Elektrode der strahlungsemittierenden Vorrichtung in Form der Aufwachselektrode gemäß verschiedenen Ausführungsbeispielen transparent und die andere Elektrode reflektierend ausgeführt sein kann. Alternativ dazu können auch beide Elektroden transparent ausgeführt sein.

Der Begriff "Bottom-Emitter", wie er hierin verwendet wird, bezeichnet eine Ausführung, die zu der Substratseite der OLED hin transparent ausgeführt ist. Beispielsweise können dazu wenigstens das Substrat 202, die Elektrode und die zwischen dem Substrat 202 und der Elektrode angeordnete Elektroden-Aufwachsschicht transparent ausgeführt sein. Eine als Bottom-Emitter ausgeführte OLED kann demnach beispielsweise in den organischen Funktionsschichten 208 erzeugte Strahlung auf der Substratseite 202 der OLED emittieren.

Der Begriff "Top-Emitter", wie er hierin verwendet wird, bezeichnet beispielsweise eine Ausführung, die zu der Seite der zweiten Elektrode der OLED hin transparent ausgeführt ist. Insbesondere können dazu die Elektroden-Aufwachsschicht und die zweite Elektrode transparent ausgeführt sein. Eine als Top-Emitter ausgeführte OLED kann demnach beispielsweise in den organischen Funktionsschichten erzeugte Strahlung auf der Seite der zusätzlichen Elektrode der OLED emittieren.

Eine als Top-Emitter ausgestaltete Lichtquellenvorrichtung 100 gemäß verschiedenen Ausführungsbeispielen, bei welchem die Elektroden-Aufwachsschicht und die Metallschicht als Deckkontakt vorgesehen sind, kann in vorteilhafter Weise eine hohe Lichtauskopplung und eine sehr geringe Winkelabhängigkeit der Strahlungsdichte aufweisen. Die strahlungsemittierende Vorrichtung gemäß verschiedenen Ausführungsbeispielen kann in vorteilhafter Weise für Beleuchtungen, wie beispielsweise Raumleuchten, eingesetzt werden.

Eine Kombination aus Bottom-Emitter und Top-Emitter ist ebenso in verschiedenen Ausführungsbeispielen vorgesehen. Bei einer solchen Ausführung ist die Lichtquellenvorrichtung 100 allgemein in der Lage, das in den organischen Funktionsschichten 208 erzeugte Licht in beide Richtungen - also sowohl zu der Substratseite als auch zu der Seite der zweiten Elektrode hin - zu emittieren.

In einer weiteren Ausführungsform ist zwischen der Elektrode und der zusätzlichen Elektrode wenigstens eine dritte Elektrode angeordnet und die Elektroden-Aufwachsschicht ist auf der dem Substrat 202 zugewandten Seite der dritten Elektrode angeordnet.

Die "dritte Elektrode" kann als Zwischenkontakt fungieren. Sie kann dazu dienen, einen Ladungstransport durch die Schichten der Lichtquellenvorrichtung 100 hindurch zu erhöhen und damit die Effizienz der Lichtquellenvorrichtung 100 zu verbessern. Die dritte Elektrode kann als ambipolare Schicht ausgestaltet sein; sie kann als Kathode oder Anode ausgestaltet sein.

Ebenso wie die Elektrode und die zusätzliche Elektrode ist die dritte Elektrode elektrisch kontaktiert.

In einer Weiterbildung der Lichtquellenvorrichtung 100 sind als organische Funktionsschichten eine Emitterschicht und eine oder mehrere weitere organische Funktionsschichten enthalten. Die weiteren organischen Funktionsschichten können ausgewählt sein aus der Gruppe, bestehend aus Lochinjektionsschichten, Lochtransportschichten, lochblockierenden Schichten, Elektroneninjektionsschichten, Elektronentransportschichten und elektronenblockierenden Schichten.

In verschiedenen Ausführungsbeispielen weist die OLED eine im Wesentlichen Lambertsche Abstrahlcharakteristik auf. Der Begriff "Lambertsche Abstrahlcharakteristik", wie er hierin verwendet wird, bezeichnet das ideale Abstrahlverhalten eines so genannten Lambert-Strahlers. Eine "im Wesentlichen" Lambertsche Abstrahlcharakteristik, wie sie hierin bezeichnet ist, meint dabei insbesondere, dass die Abstrahlcharakteristik, welche sich nach der Formel

$$I(\Theta) = I_0 \cdot \cos\Theta$$

berechnet und in der $I_0$ die Intensität bezogen auf eine Flächennormale ist und $\Theta$ den Winkel zur Flächennormalen angibt, für einen gegebenen Winkel, insbesondere bei einem Winkel zwischen -70° und +70°, für jeden gegebenen Winkel $\Theta$ um nicht mehr als 10 % von der Intensität gemäß der oben genannten Formel abweicht, also $I(\Theta) = I_0 \cdot \cos\Theta \cdot x$, wobei x = 90 % - 110 %.

Auf diese Weise kann es möglich sein, eine nach allen Richtungen konstante Strahldichte bzw. Leuchtdichte der OLED zu erreichen, so dass die OLED in allen Richtungen gleich hell scheint. Die Helligkeit der OLED kann sich in vorteilhafter Weise auch dann nicht ändern, wenn es gegenüber der Blickrichtung verkippt wird.

In einer weiteren Ausführungsform beträgt die Transparenz der OLED größer oder gleich 60 %. Beispielsweise kann die Transparenz größer oder gleich 65 % betragen. Die Transparenz wird mittels Intensitätsmessungen gemessen, indem vorgegebene Wellenlängenbereiche abgetastet und die durch die strahlungsemittierende Vorrichtung tretende Lichtmenge erfasst werden.

Der Begriff "Transparenz", wie er hierin verwendet wird, bezeichnet die Fähigkeit der einzelnen Schichten des elektronischen Bauelements gemäß verschiedenen Ausführungsbeispielen, elektromagnetische Wellen - und insbesondere sichtbares Licht - durchzulassen.

Die Transparenz der OLED gemäß verschiedenen Ausführungsbeispielen beträgt im Regelfall zumindest für wenigstens eine konkrete Wellenlänge mehr als 60 %, vorzugsweise mehr als 65 %. Beispielsweise kann die Transparenz für wenigstens eine Wellenlänge in einem Wellenlängenbereich von etwa 400 nm bis etwa 650 nm mehr als 60 % und beispielsweise mehr als 65 % betragen.

Die OLED gemäß verschiedenen Ausführungsbeispielen kann ferner weitere Funktionsschichten, wie beispielsweise Antireflexionsschichten, Streuschichten, Schichten zur Farbkonversion von Licht und/oder mechanische Schutzschichten, aufweisen. Derartige Schichten können beispielsweise auf der Metallschicht der Aufwachselektrode angeordnet sein. Die Funktionsschichten können beispielsweise mittels thermischen Verdampfens abgeschieden werden. Diese Schichten können die Funktion und Effizienz der OELD weiter verbessern.

Weiterhin kann, wie in Fig.2 dargestellt ist, die freiliegende Oberfläche des Substrats 202 auf einer Leiterplatte 102 (Printed Circuit Board, PCB) angeordnet sein, beispielsweise auf einer flexiblen Leiterplatte (Flexible Printed Circuit Board, FPCB). Die Leiterplatte 102 kann eine Materialschicht oder eine Mehrzahl (grundsätzlich eine beliebige Anzahl) von Leiterplattenschichten aufweisen. Weiterhin kann die Leiterplatte 102 eine oder mehrere (strukturierte) elektrisch leitfähige Schichten aufweisen, welche eine oder mehrere elektrisch leitfähige (beispielsweise metallische) Leiterbahnen aufweisen kann. Die Leiterplatte kann beispielsweise Kunststoff aufweisen oder daraus gefertigt sein, beispielsweise Polyimid.

Wie im Folgenden noch näher erläutert wird ermöglicht das Vorsehen einer Leiterplatte mit Leiterbahnen den Verzicht auf erheblichen Platz benötigende Kabel zur Rückführung eines elektrischen Potentials durch die Lichtquellenvorrichtung 100, wobei die Lichtquellenvorrichtung 100 überbrückt wird, ohne dass der rückgeführte elektrische Strom durch die Lichtquellenvorrichtung 100 (und damit beispielsweise durch die in Fig.2 dargestellten Schichten der OLED) selbst geführt wird, sondern lediglich durch die für die Rückführung vorgesehenen Leiterbahn(en) der Leiterplatte 102.

Die Verwendung von einer Leiterplatte oder von mehreren dünnen Leiterplatten, die auch flexibel ausgeführt sein können, ermöglichen somit in verschiedenen Ausführungsbeispielen die einfache Verdrahtung einer oder mehrerer der Flächenlichtquellen. Diese Leiterplatten können sehr dünn gestaltet werden, um den Dickenauftrag zu verringern. Mehrlagige Leiterplatten (anders ausgedrückt beispielsweise Leiterplatten mit mehreren Leiterbahnebenen) ermöglichen die Realisierung von Kreuzungspunkten in sehr dünner Art und Weise. Die Reihenschaltung mehrerer Flächenlichtquellen kann durch die Integration eines oder mehrerer Durchführungen in einer solchen Leiterplatte gelöst werden, ohne dass zusätzliche Kabel notwendig sind. Eine solche Durchführung wird in der Leiterplatte 102 durch eine leitfähige Ebene gebildet, die nur in bestimmten Teilen der Leiterplatte 102 enthalten sein braucht. Andere Bereiche der Leiterplatte 102 können bewusst ausgelassen werden, um auch transparente Flächenlichtquellen an diesen Stellen nicht zu beeinflussen. Die Ausführung als flexible Leiterplatte ermöglicht auch die Verwendung zur Kontaktierung flexibler Flächenlichtquellen.

In verschiedenen Ausführungsbeispielen weist die Lichtquellenvorrichtung 100 in Draufsicht eine beliebige Form auf, beispielsweise eine runde Form (z.B. kreisförmig oder ellipsenförmig) auf, alternativ eine Form mit einer grundsätzlich beliebigen Anzahl von Ecken und Kanten (z.B. eine polygonale Form wie beispielsweise die Form eines Dreiecks, Vierecks (z.B. Rechteck), Fünfeck, Sechseck, Siebeneck, Achteck, etc., regelmäßig oder unregelmäßig).

In der in Fig.1 dargestellten Implementierung weist die Lichtquellenvorrichtung 100 in Draufsicht die Form eines regelmäßigen Achtecks auf.

Die Leiterplatte 102 kann eine an die Form der Lichtquellenvorrichtung 100 angepasste Form aufweisen, beispielsweise in der Gesamtform oder nur in Teilen, beispielsweise in einem Außenbereich oder Randbereich der Leiterplatte 102, in dem beispielsweise Anschlüsse zum Zuführen oder Bereitstellen von elektrischer Energie (in Form von elektrischem Strom oder elektrischem Potential) vorgesehen sein·können. In verschiedenen Ausführungsbeispielen weist die Leiterplatte 102 eine Ringform auf, die einen ringförmigen Bereich 104 und an einigen Bereichen entlang des Umfangs des ringförmigen Bereichs 104 sich nach außen erstreckende Rechteckbereiche 106 aufweist.

Die Leiterplatte 102 weist in verschiedenen Ausführungsbeispielen mehrere mit der Lichtquelle 200 gekoppelte Anschlüsse 108 auf, die je nach externer Kontaktierung als Eingangsanschlüsse oder als Ausgangsanschlüsse dienen können.

In verschiedenen Ausführungsbeispielen kann jeder der Anschlüsse 108 einen ersten Potential-Anschluss 110 zum vorrichtungsexternen Kontaktieren mit einem ersten elektrischen Potential (beispielsweise einen ersten Potential-Eingangsanschluss 110 zum Zuführen eines ersten elektrischen Potentials oder einen ersten Potential-Ausgangsanschluss 110 zum Bereitstellen eines ersten elektrischen Potentials) aufweisen sowie einen zweiten Potential-Anschluss 112 zum vorrichtungsexternen Kontaktieren mit einem zweiten elektrischen Potential (welches gleich oder unterschiedlich sein kann wie das erste elektrische Potential (beispielsweise einen zweiten Potential-Eingangsanschluss 112 zum Zuführen eines zweiten elektrischen Potentials oder einen zweiten Potential-Ausgangsanschluss 112 zum Bereitstellen eines zweiten elektrischen Potentials). Das erste elektrische Potential kann positiver sein als das zweite elektrische Potential und ist in Fig.1 auch mit dem Symbol "+" bezeichnet; entsprechend ist das zweite elektrische Potential in Fig.1 auch mit dem Symbol "-" bezeichnet.

Auch wenn bei der Leiterplatte 102 gemäß Fig.1 acht Anschlüsse 108 vorgesehen sind, ist anzumerken, dass grundsätzlich eine beliebige Anzahl von Anschlüssen vorgesehen sein kann, beispielsweise zwei, drei, vier, fünf, sechs, sieben, acht oder mehr.

Der erste Potential-Anschluss 110 kann in verschiedenen Ausführungsbeispielen mit einem ersten Kontakt, beispielsweise der ersten Elektrode (beispielsweise der ersten Elektrode 204), beispielsweise der Anode, der Lichtquelle 200 verbunden sein, und der zweite Potential-Anschluss 112 kann mit einem zweiten Kontakt, beispielsweise der zweiten Elektrode (beispielsweise der zweiten Elektrode 208), beispielsweise der Kathode, der Lichtquelle 200 verbunden sein. In alternativen Ausführungsbeispielen kann der erste Potential-Anschluss 110 mit der Kathode der Lichtquelle 200 verbunden sein und der zweite Potential-Anschluss 112 kann mit der Anode der Lichtquelle 200 verbunden sein.

Weiterhin kann gemäß verschiedenen Ausführungsbeispielen jeder der Anschlüsse 108 einen Überbrückungsanschluss 114 (im Folgenden auch bezeichnet als Durchleitungsanschluss 114) aufweisen. Ein Überbrückungsanschluss 114 ist in verschiedenen Ausführungsbeispielen elektrisch nicht mit der Lichtquelle 200 selbst gekoppelt, sondern mittels einer oder mehreren Leiterbahnen der Leiterplatte 102 mit einem anderen Überbrückungsanschluss 114 der Leiterplatte 102, womit ein an einen Überbrückungsanschluss 114 der Leiterplatte 102 angelegtes elektrisches Potential lediglich durch die Leiterplatte 102 an der Lichtquelle 200 vorbei "durchgeschleift" wird und an dem anderen Überbrückungsanschluss 114, mit dem der Überbrückungsanschluss 114 gekoppelt ist, extern einer anderen Lichtquellenvorrichtung 102 oder einem anderen elektronischen Gerät bereitgestellt wird. In verschiedenen Ausführungsbeispielen ist die mindestens eine als Rückführung dienende Leiterbahn in die Leiterplatte 102 (monolithisch) integriert.

Es ist anzumerken, dass in verschiedenen Ausführungsbeispielen ein oder mehrere Überbrückungsanschlüsse 114 unabhängig von einem Anschluss 108 und beispielsweise unabhängig von den Potential-Anschlüssen der Anschlüsse 108, wie sie oben beschrieben worden sind, separat vorgesehen sein können.

Weiterhin kann die Leiterplatte 102 noch eine Schutzdiode 116, beispielsweise in Form einer Schottky-Diode 116, aufweisen.

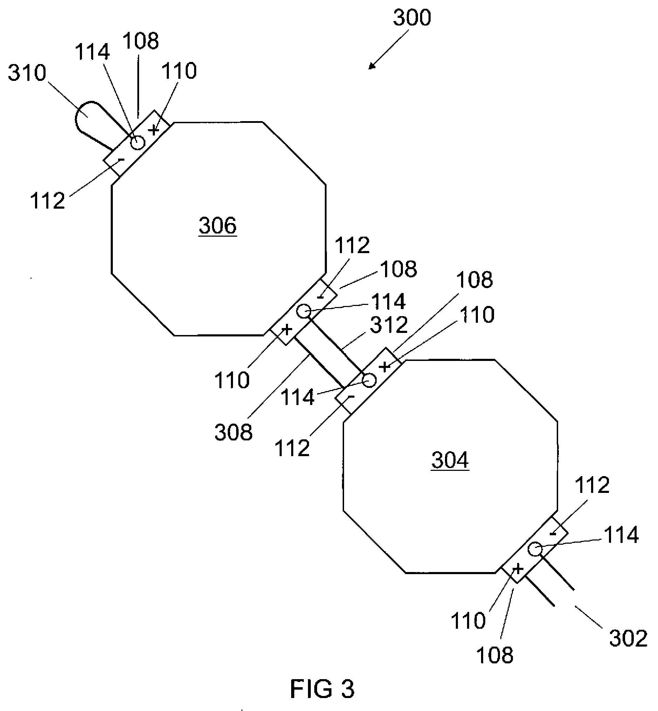

**Fig.3** zeigt eine Draufsicht auf eine Lichtquellenanordnung 300 gemäß einem Ausführungsbeispiel mit einer Mehrzahl von Lichtquellenvorrichtungen 100. In der Lichtquellenanordnung 300 sind zwei Lichtquellenvorrichtungen 100 (beispielsweise eine erste Lichtquellenvorrichtung 304 und eine zweite Lichtquellenvorrichtung 306), implementiert jeweils als Flächenstrahler-Vorrichtungen mit jeweils mindestens einem Flächenstrahler, beispielsweise implementiert als OLEDs, dargestellt, obwohl in verschiedenen Ausführungsbeispielen die Lichtquellenanordnung 300 eine beliebige Anzahl von miteinander in Reihenschaltung und/oder in Parallelschaltung elektrisch verbundenen Flächenstrahler aufweisen kann, beispielsweise zwei, drei, vier, fünf, oder mehr.

Wie in Fig.3 gezeigt weist die Lichtquellenanordnung 300 einen Eingangs-Anschluss 302 auf, der ein Anschluss 108 einer Leiterplatte 102 der ersten Lichtquellenvorrichtung 304 sein kann, die als Eingangs-Lichtquellenvorrichtung 304 der Lichtquellenanordnung 300 vorgesehen sein kann.

Ein als Ausgangs-Anschluss dienender zusätzlicher Anschluss 108 der Leiterplatte 102 der Eingangs-Lichtquellenvorrichtung 304 ist mit einem als Eingangs-Anschluss dienenden Anschluss 108 der Leiterplatte 102 der zweiten Lichtquellenvorrichtung 306 mittels eines elektrischen Verbinders 308 elektrisch verbunden. Der Verbinder 308 kann beispielsweise mittels eines Drahtes, eines Kabels oder in anderer Form vorgesehen sein zum Bereitstellen des zweiten elektrischen Potentials (auf ein Anlegen des ersten elektrischen Potentials "+" an den ersten Potential-Eingangsanschluss 110, welches somit an den Flächenstrahler (beispielsweise die OLED) der ersten Lichtquellenvorrichtung 304 angelegt wird, hin) von dem zweiten Potential-Eingangsanschluss 112 des zusätzlichen Anschlusses, d.h. des Ausgangs-Anschlusses 108 der ersten Lichtquellenvorrichtung 304 an einem als Eingangs-Anschluss dienenden Anschluss 108 (genauer an dem ersten Potential-Eingangsanschluss 110 des Eingangs-Anschlusses 108) der zweiten Lichtquellenvorrichtung 306. Ein erstes Ende des Verbinders 308 ist mit dem zweiten Potential-Eingangsanschluss 112 des zusätzlichen Anschlusses der ersten Lichtquellenvorrichtung 304 gekoppelt und ein zweites Ende des Verbinders 308 ist mit dem ersten Potential-Eingangsanschluss 110 des Eingangs-Anschlusses der zweiten Lichtquellenvorrichtung 306 gekoppelt, beispielsweise angesteckt oder angelötet oder angeklebt oder in sonstiger geeigneter Weise mechanisch und elektrisch gekoppelt.

Weiterhin ist ein Kurzschlussverbinder 310 vorgesehen, dessen erstes Ende mit einem zweiten Potential-Eingangsanschluss 112 eines zusätzlichen Anschlusses der zweiten Lichtquellenvorrichtung 306 gekoppelt ist und dessen zweites Ende mit einem Überbrückungsanschluss 114 des zusätzlichen Anschlusses der zweiten Lichtquellenvorrichtung 306 gekoppelt ist, beispielsweise angesteckt oder angelötet oder angeklebt oder in sonstiger geeigneter Weise mechanisch und elektrisch gekoppelt.

Anschaulich wird somit das an dem zweiten Potential-Eingangsanschluss 112 des zusätzlichen Anschlusses 108 der zweiten Lichtquellenvorrichtung 306 bereitgestellte elektrische Potential (anschaulich in Form eines Kurzschlusses) rückgeführt an den Überbrückungsanschluss 114 des zusätzlichen Anschlusses 108 der zweiten Lichtquellenvorrichtung 306. Der Überbrückungsanschluss 114 ist, wie oben beschrieben worden ist, direkt mit einem anderen Überbrückungsanschluss 114, in diesem Beispiel mit dem Überbrückungsanschluss 114 des Eingangs-Anschlusses 108 der zweiten Lichtquellenvorrichtung 306, verbunden und überbrückt anschaulich die Lichtquelle 200 der zweiten Lichtquellenvorrichtung 306 mittels der Leiterbahn der Leiterplatte 102 der zweiten Lichtquellenvorrichtung 306.

Der Kurzschlussverbinder 310 kann an den zweiten Potential-Eingangsanschluss 112 und den Überbrückungsanschluss 114 beispielsweise angesteckt sein oder angelötet oder angeklebt oder in sonstiger geeigneter Weise mechanisch und elektrisch gekoppelt.

Somit liegt das an dem zweiten Potential-Eingangsanschluss 112 des zusätzlichen Anschlusses der zweiten Lichtquellenvorrichtung 306 bereitgestellte elektrische Potential (natürlich abzüglich der durch den elektrischen Widerstand der Leiterbahn und der Anschlüsse verursachten Verluste) auch an dem Überbrückungsanschluss 114 des Eingangs-Anschlusses 108 der zweiten Lichtquellenvorrichtung 306 an. Damit ist anschaulich das an dem zweiten Potential-Eingangsanschluss 112 des zusätzlichen Anschlusses 108 der zweiten Lichtquellenvorrichtung 306 bereitgestellte elektrische Potential an deren Eingangs-Anschluss 108 über die Leiterbahn (und nicht wie im Stand der Technik mittels eines Kabels) rückgeführt, wobei die Lichtquelle, beispielsweise die OLED der zweiten Lichtquellenvorrichtung 306, überbrückt wird und somit nicht als elektrische Last in der Rückführung wirkt.

Der Überbrückungsanschluss 114 des Eingangs-Anschlusses 108 der zweiten Lichtquellenvorrichtung 306 ist ferner beispielsweise mit dem Überbrückungsanschluss 114 des zusätzlichen Anschlusses 108 der ersten Lichtquellenvorrichtung 304 mittels eines zusätzlichen Verbinders 312 elektrisch verbunden, welcher seinerseits, wie oben beschrieben worden ist, direkt mit einem anderen Überbrückungsanschluss 114, in diesem Beispiel mit dem Überbrückungsanschluss 114 des Eingangs-Anschlusses 108 der ersten Lichtquellenvorrichtung 304, verbunden ist und anschaulich die Lichtquelle 200 der ersten Lichtquellenvorrichtung 304 mittels der Leiterbahn der Leiterplatte 102 der ersten Lichtquellenvorrichtung 304 überbrückt.

Der zusätzliche Verbinder 312 kann in verschiedenen Ausführungsbeispielen mittels eines Drahtes, eines Kabels oder in anderer Form vorgesehen sein. Ein erstes Ende des zusätzlichen Verbinders 312 ist mit dem Überbrückungsanschluss 114 des Eingangs-Anschlusses 108 der zweiten Lichtquellenvorrichtung 306 gekoppelt und ein zweites Ende des zusätzlichen Verbinders 312 ist mit dem Überbrückungsanschluss 114 des Eingangs-Anschlusses 108 der zweiten Lichtquellenvorrichtung 306 des Ausgangs-Anschlusses 108 der ersten Lichtquellenvorrichtung 304 gekoppelt, beispielsweise angesteckt oder angelötet oder angeklebt oder in sonstiger geeigneter Weise mechanisch und elektrisch gekoppelt.

Somit liegt das an dem zweiten Potential-Eingangsanschluss 112 des zusätzlichen Anschlusses 108 der zweiten Lichtquellenvorrichtung 306 bereitgestellte elektrische Potential (natürlich abzüglich der durch den elektrischen Widerstand der Leiterbahn und der Anschlüsse verursachten Verluste) auch an dem Überbrückungsanschluss 114 des Eingangs-Anschlusses 108 der ersten Lichtquellenvorrichtung 304 an. Damit ist anschaulich das an dem zweiten Potential-Eingangsanschluss 112 des zusätzlichen Anschlusses 108 der zweiten Lichtquellenvorrichtung 306 bereitgestellte elektrische Potential an dem Eingangs-Anschluss 108 der ersten Lichtquellenvorrichtung 304 über die Leiterbahnen (und nicht wie im Stand der Technik mittels Kabeln) rückgeführt an den Eingangs-Anschuss 302 der Lichtquellenanordnung 300, wobei die Lichtquellen aller Lichtquellenvorrichtungen des (im Allgemeinen beliebig ausgeführten) Rückführpfades durch die jeweiligen Lichtquellenvorrichtungen, beispielsweise die OLED der zweiten Lichtquellenvorrichtung 306 sowie die OLED der ersten Lichtquellenvorrichtung 304, überbrückt werden und somit nicht als elektrische Last in der Rückführung wirken.

Damit wird eine einfache und platzsparende Möglichkeit der Bereitstellung eines gemeinsamen Eingangs-Anschlusses 302 der Lichtquellenanordnung 300 erreicht.

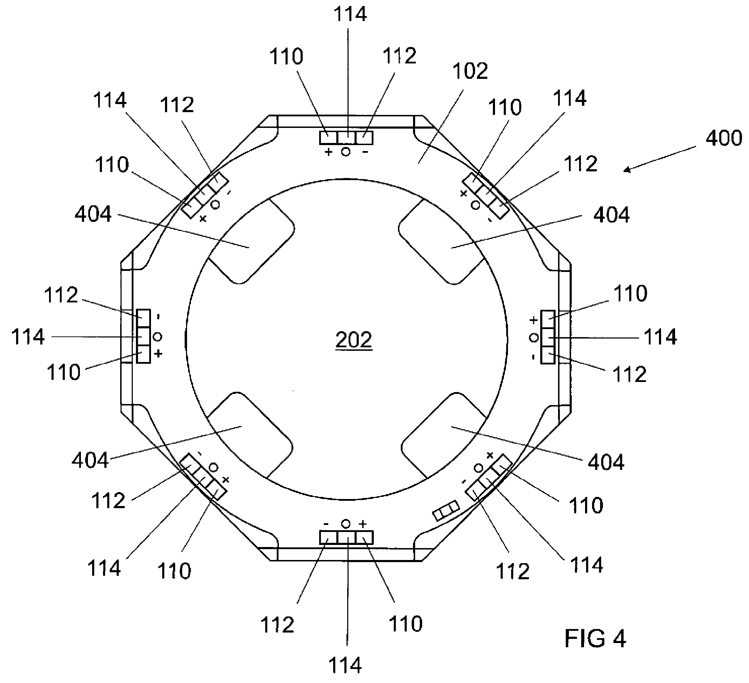

**Fig.4** zeigt eine Draufsicht auf eine Lichtquellenvorrichtung 400 gemäß einem Ausführungsbeispiel.

Die in Fig.4 gezeigte Lichtquellenvorrichtung 400 weist eine flexible Leiterplatte 102 (FPCB) auf mit acht Anschlüssen 108, die jeweils gemäß den Anschlüssen 108 der Lichtquellenvorrichtung 100 gemäß Fig.1 eingerichtet sein können. Weiterhin ist in Fig.4 die in der flexiblen Leiterplatte 102 integrierte Leiterbahn 402 dargestellt. Die Leiterbahn 402 ist mit den Überbrückungsanschlüssen 114 aller Anschlüsse 108 der Leiterplatte 102 elektrisch gekoppelt und von der Lichtquelle 200 der Lichtquellenvorrichtung 400 elektrisch isoliert und überbrückt dieselbe.

Weiterhin weist die Lichtquellenvorrichtung 400 in verschiedenen Ausführungsbeispielen eine oder mehrere Getter-Elemente 404 auf, die aus einem Getter-Material bestehen oder dieses aufweisen zum Binden beispielsweise von Sauerstoff und/oder Wasser oder dergleichen.

Die Lichtquellenvorrichtung 400 kann beispielsweise ebenfalls in der Lichtquellenanordnung 300 anstelle der Lichtquellenvorrichtung 100 aus Fig.1 vorgesehen sein und kann beispielsweise eine Flächenlichtquelle, wie sie oben beispielhaft erläutert worden ist, beispielsweise eine OLED (beispielsweise die OLED 200), als Lichtquelle aufweisen.

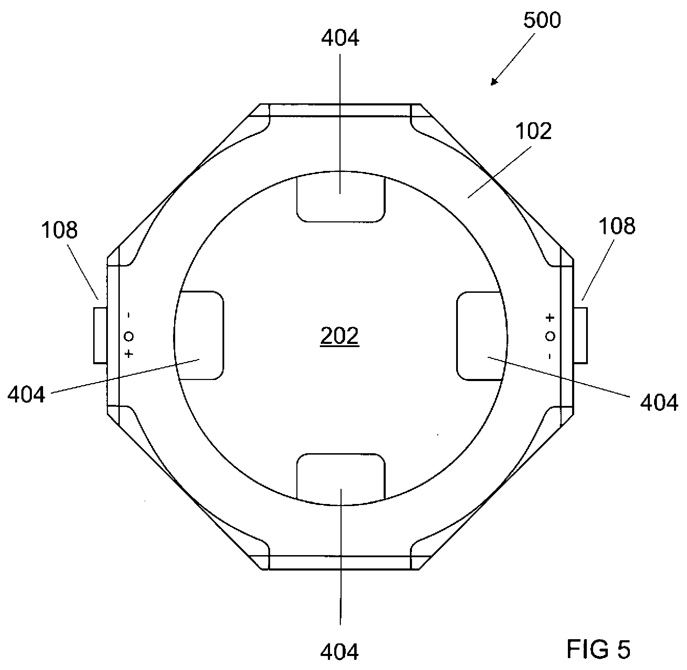

**Fig.5** zeigt eine Draufsicht auf eine Lichtquellenvorrichtung 500 gemäß einem Ausführungsbeispiel.

Die in Fig.5 gezeigte Lichtquellenvorrichtung 500 weist eine flexible Leiterplatte 102 (FPCB) auf mit zwei Anschlüssen 108, die jeweils gemäß den Anschlüssen der Lichtquellenvorrichtung 100 gemäß Fig.1 eingerichtet sind. Die in Fig.5 nicht dargestellte Leiterbahn ist mit den Überbrückungsanschlüssen 114 beider Anschlüsse 108 elektrisch gekoppelt und von der Lichtquelle 200 der Lichtquellenvorrichtung 400 elektrisch isoliert und überbrückt dieselbe.

Weiterhin weist die Lichtquellenvorrichtung 500 in verschiedenen Ausführungsbeispielen eine oder mehrere Getter-Elemente 404 auf, die aus einem Getter-Material bestehen oder dieses aufweisen zum Binden beispielsweise von Sauerstoff und/oder Wasser oder dergleichen.

Die Lichtquellenvorrichtung 500 kann beispielsweise ebenfalls in der Lichtquellenanordnung 300 anstelle der Lichtquellenvorrichtung 100 aus Fig.1 vorgesehen sein und kann beispielsweise eine Flächenlichtquelle, wie sie oben beispielhaft erläutert worden ist, beispielsweise eine OLED (beispielsweise die OLED 200), als Lichtquelle aufweisen.

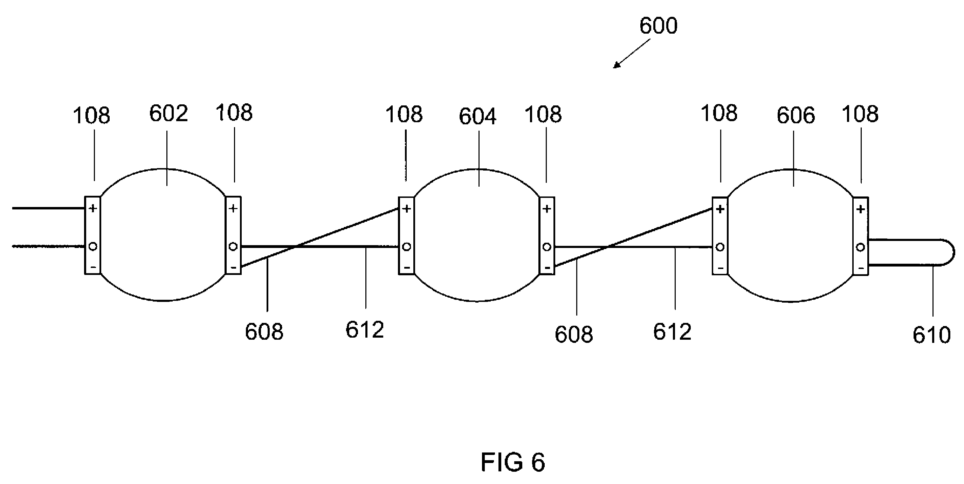

**Fig.6** zeigt eine Lichtquellenanordnung 600 gemäß einem Ausführungsbeispiel.

In dieser Lichtquellenanordnung 600 sind drei Lichtquellenvorrichtungen (beispielsweise eine erste Lichtquellenvorrichtung 602, eine zweite Lichtquellenvorrichtung 604, sowie eine dritte Lichtquellenvorrichtung 606) miteinander mittels Kabeln oder Drähten 608 in Serie gekoppelt und mittels eines Kurzschlussverbinders 610 (angeschlossen am Ende der Serienschaltung, beispielsweise an den zweiten Potentialanschluss 112 der dritten Lichtquellenvorrichtung 606 sowie an den Überbrückungsanschluss 114 der dritten Lichtquellenvorrichtung 606) an die lastfreie Rückführung. Die lastfreie Rückführung zu dem Eingangs-Anschluss der ersten Lichtquellenvorrichtung 602 wird gebildet von den Leiterbahnen der Leiterplatten der Lichtquellenvorrichtungen 602, 604, 606, sowie Rückführverbindern 612, 614, welche gekoppelt sind mit den Überbrückungsanschlüssen 114 der jeweiligen in dem Rückführungspfad zu dem Eingangs-Anschluss der ersten Lichtquellenvorrichtung 602 sich befindenden Lichtquellenvorrichtungen 602, 604, 606. Die Lichtquellenvorrichtungen können gemäß den in Fig.1, Fig.4 oder Fig.5 dargestellten Lichtquellenvorrichtungen 100, 400, 500 eingerichtet sein, allgemein können sie jeweils eine Leiterplatte aufweisen, in welche eine die Überbrückung der Lichtquelle bildende Leiterbahn integriert sein kann.

In verschiedenen Ausführungsbeispielen wird eine sehr flache Integration von Flächenlichtquellen in verschiedenen Applikationen (zum Beispiel Leuchten, Möbel, Fahrzeugen oder Konsumgütern), durch Vermeidung eines Dickenauftrages von Drähten hinter den Flächenlichtquellen, bereitgestellt.

Weiterhin ist in verschiedenen Ausführungsbeispielen eine Verwendung nur einer Kontaktiertechnologie ermöglicht und nicht die Mischung mehrerer verschiedener Kontaktiertechnologien erforderlich.

Eine Kabelführung im Bereich einer OLED mit all den dafür notwendigen Materialien kann in verschiedenen Ausführungsbeispielen entfallen.

In verschiedenen Ausführungsbeispielen wird die Durchführung in der Leiterplatte einer Lichtquellenvorrichtung als leitfähige Ebene (beispielsweise in Form einer oder mehrerer Leiterbahnen) ausgeführt, die nur in bestimmten Teilen der Leiterplatte enthalten ist. In verschiedenen Ausführungsbeispielen ist beispielsweise die Leiterplatte ringförmig mit einem inneren Hohlraum eingerichtet.

Mechanischer Druck auf die Flächenlichtquelle wird durch die Verwendung einer homogenen Leiterplatte gemäß verschiedenen Ausführungsbeispielen gleichmäßig über die Fläche verteilt und wirkt nicht punktuell wie beispielsweise an parallel geführten Kabeln.

**Patentansprüche**

1. Lichtquellenvorrichtung (100), aufweisend:

   • eine Lichtquelle (200) mit einer ersten Elektrode (204, 208) und einer zweiten Elektrode (204, 208);
   • einen Eingangsanschluss (108) ;
   • einen Ausgangsanschluss (108) ;

   **gekennzeichnet durch**

   • einen ersten Überbrückungsanschluss (114) und einen zweiten Überbrückungsanschluss (114); und
   • eine mit der Lichtquelle (200) gekoppelte Leiterplatte (102);
   • wobei die Leiterplatte (102) mindestens eine Leiterbahn (402) aufweist, die mit dem ersten Überbrückungsanschluss (114) und dem zweiten Überbrückungsanschluss (114) gekoppelt ist zum von der Lichtquelle (200) elektrisch isolierten, überbrückenden Führen eines elektrischen Potentials von dem ersten Überbrückungsanschluss (114) zu dem zweiten Überbrückungsanschluss (114);
   • wobei der Eingangsanschluss (108) einen ersten Potential-Eingangsanschluss (110, 112) und einen zweiten Potential-Eingangsanschluss (110, 112) aufweist, wobei der Eingangsanschluss (108) derart ausgebildet und mit der Lichtquelle (200) verbunden ist, dass der erste Potential-Eingangsanschluss (110, 112) zum Zuführen eines ersten elektrischen Potentials ausgebildet ist, und der zweite Potential-Eingangsanschluss (110, 112) zum Zuführen eines zweiten elektrischen Potentials ausgebildet ist, wobei der erste Potential-Eingangsanschluss (110, 112) mit der ersten Elektrode und der zweite Potential-Eingangsanschluss (110, 112) mit der zweiten Elektrode verbunden ist und wobei das zweite elektrische Potential unterschiedlich ist zu dem ersten elektrischen Potential; und

• wobei der Ausgangsanschluss (108) einen ersten Potential-Ausgangsanschluss (110, 112) und einen zweiten Potential-Ausgangsanschluss (110, 112) aufweist, wobei der Ausgangsanschluss (108) derart ausgebildet und mit der Lichtquelle (200) verbunden ist, dass der erste Potential-Ausgangsanschluss (110, 112) zum Bereitstellen eines ersten elektrischen Potentials ausgebildet ist, und der zweite Potential-Ausgangsanschluss (110, 112) zum Bereitstellen eines zweiten elektrischen Potentials ausgebildet ist, und wobei der erste Potential-Ausgangsanschluss (110, 112) mit der ersten Elektrode und der zweite Potential-Ausgangsanschluss (110, 112) mit der zweiten Elektrode verbunden ist und wobei das zweite elektrische Potential unterschiedlich ist zu dem ersten elektrischen Potential.

2. Lichtquellenvorrichtung (100) gemäß Anspruch 1, wobei die Lichtquelle (200) ein Substrat (20) mit einer freiliegenden Oberfläche aufweist, wobei die freiliegende Oberfläche auf der Leiterplatte (102) angeordnet ist.

3. Lichtquellenvorrichtung (100) gemäß einem der Ansprüche 1 bis 2, wobei die Lichtquelle (200) eine oder mehrere organische Funktionsschichten (206) aufweist, wobei die eine oder mehrere organische Funktionsschichten (206) auf der ersten Elektrode ausgebildet ist und die zweite Elektrode auf der einen oder mehreren organischen Funktionsschichten (206) ausgebildet ist, oder wobei die eine oder mehrere organische Funktionsschichten (206) auf der zweiten Elektrode ausgebildet ist und die erste Elektrode auf der einen oder mehreren organischen Funktionsschichten (206) ausgebildet ist.

4. Lichtquellenvorrichtung (100) gemäß einem der Ansprüche 1 bis 3, wobei die Lichtquelle (200) als eine Flächenlichtquelle (200) eingerichtet ist.

5. Lichtquellenvorrichtung (100) gemäß Anspruch 4, wobei die Flächenlichtquelle (200) eingerichtet ist als mindestens eine der folgenden Flächenlichtquellen (200):

eine Leuchtdiode, eine organische Leuchtdiode, eine OLEC-Lichtquelle.

6. Lichtquellenvorrichtung (100) gemäß einem der Ansprüche 1 bis 5, wobei die Leiterplatte (102) als eine flexible Leiterplatte (102) eingerichtet ist.

7. Lichtquellenvorrichtung (100) gemäß einem der Ansprüche 1 bis 6, wobei der Eingangsanschluss (108) auf der Leiterplatte (102) angeordnet ist.

8. Lichtquellenvorrichtung (100) gemäß einem der Ansprüche 1 bis 7, wobei der Ausgangsanschluss (108) auf der Leiterplatte (102) angeordnet ist.

9. Lichtquellenvorrichtung (100) gemäß einem der Ansprüche 1 bis 8, wobei der erste Überbrückungsanschluss (114) und/oder der zweite Überbrückungsanschluss (114) auf der Leiterplatte (102) angeordnet sind/ist.

10. Lichtquellenanordnung (300) mit einer Mehrzahl miteinander elektrisch gekoppelten Lichtquellenvorrichtungen (100) gemäß einem der Ansprüche 1 bis 9.

**Claims**

1. A light source device (100), comprising:

• a light source (200) comprising a first electrode (204, 208) and a second electrode (204, 208);
• an input terminal (108);
• an output terminal (108);

**characterized by**:

• a first bridging terminal (114) and a second bridging terminal (114); and
• a printed circuit board (102) coupled to the light source (200);
• wherein the printed circuit board (102) has at least one conductor track (402) coupled to the first bridging terminal (114) and the second bridging terminal (114) for guiding an electrical potential electrically isolated from the first bridging terminal (114) to the second bridging terminal (114) in a manner that bridges the light source,
• wherein the input terminal (108) comprises a first potential input terminal (110, 112) and a second potential input terminal (110, 112), wherein the input terminal (108) is configured and coupled to the light source (200) such that the first potential input terminal (110, 112) is configured to supply a first electrical potential, and the second potential input terminal (110, 112) is configured to supply a second electrical potential, wherein the first potential input terminal (110, 112) is coupled to the first electrode and the second potential input terminal (110, 112) is coupled to the second electrode and wherein the second electrical is different from the first electrical potential; and

• wherein the output terminal (108) comprises a first potential output terminal (110, 112) and a second potential output terminal (110, 112), wherein the output terminal (108) is configured and coupled to the light source (200) such that the first potential output terminal (110, 112) is configured to supply a first electrical potential, and the second potential output terminal (110, 112) is configured to supply a second electrical potential, and wherein the first potential output terminal (110, 112) is coupled to the first electrode and the second potential output terminal (110, 112) is coupled to the second electrode and wherein the second electrical is different from the first electrical potential.

2. The light source device (100) as claimed in claim 1, wherein the light source (200) comprises a substrate (20) having a free surface wherein the free surface is arranged on the printed circuit board (102).

3. The light source device (100) as claimed in claim 1 or 2,
wherein the light source (200) comprises one or more organic functional layers (206),
wherein the one or more organic functional layers (206) are formed on the first electrode and the second electrode is formed on the one or more organic functional layers, or
wherein the one or more organic functional layers (206) are formed on the second electrode and the first electrode is formed on the one or more organic functional (206) layers.

4. The light source device (100) of any one of claims 1 to 3,
wherein the light source (200) is configured as a flat light source.

5. The light source device (100) as claimed in claim 4, wherein the flat light source (200) is configured as at least one of the following flat light sources (200): a light-emitting diode, an organic light-emitting diode, an OLEC light source.

6. The light source device (100) of any one of claims 1 to 5,
wherein the printed circuit board (102) is arranged as a flexible printed circuit board (102).

7. The light source device (100) of any one of claims 1 to 6,
wherein the input terminal (108) is positioned on the printed circuit board (102).

8. The light source device (100) of any one of claims 1 to 7,
wherein the output terminal (108) is arranged on the printed circuit board (102).

9. The light source device (100) of any one of claims 1 to 8,
wherein the first bridging terminal (114) and/or the second bridging terminal (114) is/are positioned on the printed circuit board (102).

10. The light source arrangement (300) with a plurality of light source devices (100) of any one of claims 1 to 9 electrically coupled together.

**Revendications**

1. Dispositif de source lumineuse (100), comportant :

- une source lumineuse (200) ayant une première électrode (204, 208) et une seconde électrode (204, 208) ;
- une borne d'entrée (108) ;
- une borne de sortie (108),

**caractérisée par**

- une première borne de pontage (114) et une seconde borne de pontage (114) ; et
- une carte de circuit imprimé (102) connectée à la source lumineuse (200),
- dans lequel la carte de circuit imprimé (102) comporte au moins une piste conductrice (402) qui est connectée à la première borne de pontage (114) et à la seconde borne de pontage (114) pour l'acheminement par pontage de manière électriquement isolée par rapport à la source lumineuse (200) d'un potentiel électrique de la première borne de pontage (114) à la seconde borne de pontage (114) ;
- dans lequel la borne d'entrée (108) comporte une première borne d'entrée de potentiel (110, 112) et une seconde borne d'entrée de potentiel (110, 112), dans lequel la borne d'entrée (108) est conçue et est reliée à la source lumineuse (200) de manière à ce que la première borne d'entrée de potentiel (110, 112) soit réalisée pour acheminer un premier potentiel électrique, et la seconde borne d'entrée de potentiel (110, 112) est réalisée pour acheminer un second potentiel électrique, dans lequel la première borne d'entrée de potentiel (110, 112) est reliée à la première électrode et la seconde borne d'entrée de potentiel (110, 112) est reliée à la seconde électrode, et dans lequel le second potentiel électrique est différent du premier potentiel électrique ; et
- dans lequel la borne de sortie (108) comporte une première borne de sortie de potentiel (110, 112) et une seconde borne de sortie de potentiel (110, 112), dans lequel la borne de sortie (108) est conçue et est reliée à la source lumineuse (200) de manière à ce que la première borne de sortie de potentiel (110, 112) soit réalisée pour fournir un premier potentiel électrique, et la seconde borne de sortie de potentiel (110, 112) est réalisée pour fournir un second potentiel électrique, et dans lequel la première borne de sortie de potentiel (110, 112) est reliée à la première électrode et la seconde borne de sortie de potentiel (110, 112) est reliée à la seconde électrode et dans lequel le second potentiel électrique est différent du premier potentiel électrique.

2. Dispositif de source lumineuse (100) selon la revendication 1, dans lequel la source lumineuse (200) comporte un substrat (20) présentant une surface exposée, dans lequel la surface exposée est disposée sur la carte de circuit imprimé (102).

3. Dispositif de source lumineuse (100) selon l'une quelconque des revendications 1 et 2,
dans lequel la source lumineuse (200) comporte une ou plusieurs couches fonctionnelles organiques (206),
dans lequel lesdites une ou plusieurs couches fonctionnelles organiques (206) sont formées sur la première électrode et la seconde électrode est formée sur lesdites une ou plusieurs couches fonctionnelles organiques (206), ou
dans lequel lesdites une ou plusieurs couches fonctionnelles organiques (206) sont formées sur la seconde électrode et la première électrode est formée sur lesdites une ou plusieurs couches fonctionnelles organiques (206).

4. Dispositif de source lumineuse (100) selon l'une quelconque des revendications 1 à 3,
dans lequel la source lumineuse (200) est réalisée sous la forme d'une source lumineuse de surface (200).

5. Dispositif de source lumineuse (100) selon la revendication 4,
dans lequel la source lumineuse de surface (200) est réalisée sous la forme d'au moins l'une des sources lumineuses de surface (200) suivantes :

une diode électroluminescente, une diode électroluminescente organique, une source lumineuse de type OLEC.

6. Dispositif de source lumineuse (100) selon l'une quelconque des revendications 1 à 5,
dans lequel la carte de circuit imprimé (102) est réalisée sous la forme d'une carte de circuit imprimé (102) flexible.

7. Dispositif de source lumineuse (100) selon l'une quelconque des revendications 1 à 6,
dans lequel la borne d'entrée (108) est disposée sur la carte de circuit imprimé (102).

8. Dispositif de source lumineuse (100) selon l'une quelconque des revendications 1 à 7,
dans lequel la borne de sortie (108) est disposée sur la carte de circuit imprimé (102).

9. Dispositif de source lumineuse (100) selon l'une quelconque des revendications 1 à 8,
dans lequel la première borne de pontage (114) et/ou la seconde borne de pontage (114) sont/est disposée(s) sur la carte de circuit imprimé (102).

10. Système de source lumineuse (300) comportant une pluralité de dispositifs de sources lumineuses (100) selon l'une quelconque des revendications 1 à 9 électriquement connectées les unes aux autres.

FIG 1

EP 2 529 604 B1

FIG 2

FIG 3

FIG 4

FIG 5

FIG 6

**EP 2 529 604 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007042761 A1